(19) Europäisches Patentamt

European Patent Office

Office européen des brevets

(11) EP 1 732 143 A1

(12) EUROPEAN PATENT APPLICATION
published in accordance with Art. 158(3) EPC

(43) Date of publication:
13.12.2006 Bulletin 2006/50

(51) Int Cl.:
H01L 31/12 (2006.01)          H01J 29/28 (2006.01)

(21) Application number: 05727881.4

(22) Date of filing: 29.03.2005

(86) International application number:
PCT/JP2005/005931

(87) International publication number:
WO 2005/096398 (13.10.2005 Gazette 2005/41)

(84) Designated Contracting States:
DE FR GB IT NL

(30) Priority: 02.04.2004 JP 2004110119

(71) Applicant: KABUSHIKI KAISHA TOSHIBA
Tokyo 105-8001 (JP)

(72) Inventor: MURATA, Hirotaka,
Intellectual Property Division
Minato-ku,
Tokyo 105-8001 (JP)

(74) Representative: HOFFMANN EITLE
Patent- und Rechtsanwälte
Arabellastrasse 4
81925 München (DE)

(54) IMAGE DISPLAY

(57)     A front substrate (11), which forms an image display device, includes a metal back layer which is laid over a phosphor screen and is composed of a plurality of divisional electrodes (30). A first gap (gs) is provided between neighboring divisional electrodes (30) in a first region (As) on the front substrate (11). A second gap (ge), which is greater than the first gap (gs), is provided between neighboring divisional electrodes (30) in a second region (Ae) which is located at a periphery of the first region (As). The second region (Ae) includes, at least at a part thereof, a region (Aer) having a lower resistance than the first region (As).

FIG. 5

EP 1 732 143 A1

## Description

Technical Field

The present invention relates to an image display device, and more particularly to a flat-screen image display device including a pair of substrates which are disposed to be opposed to each other.

Background Art

In recent years, a flat-screen image display device, in which a great number of electron emitter elements are arranged and disposed to be opposed to a phosphor surface, has been developed as a next-generation image display device. There are various types of electron emitter elements. Basically, any type of electron emitter element makes use of field emission. A display device using electron emitter elements is generally called a "field emission display" (FED). Of FEDs, a display device using surface-conduction-type electron emitter elements is called a "surface-conduction electron-emitter display" (SED). In the present specification, the term "FED" is used as a general term including a SED.

A FED generally includes a front substrate and a back substrate which are disposed to be opposed to each other with a predetermined gap. Peripheral parts of these substrates are attached to each other via a rectangular-frame-shaped side wall. Thereby, a vacuum envelope is constituted. The inside of the vacuum envelope is kept at a high degree of vacuum of about $10^{-4}$ Pa or less. A plurality of spacers is provided between the back substrate and the front substrate in order to support an atmospheric-pressure load acting on these substrates.

A phosphor surface including red, blue and green phosphor layers is formed on the inner surface of the front substrate. A great number of electron emitter elements, which emit electrons for exciting phosphors to emit light, are provided on the inner surface of the back substrate. A great number of scan lines and signal lines are formed in a matrix and connected to the respective electron emitter elements. An anode voltage is applied to the phosphor surface. Electron beams, which are emitted from the electron emitter elements, are accelerated by the anode voltage and caused to strike the phosphor surface. Thereby, the phosphors are caused to emit light, and an image is displayed.

In a FED, the gap between the front substrate and back substrate can be set at several mm or less. Compared to cathode-ray tubes (CRTs) which are conventionally used as displays of TVs or computers, the weight and thickness can be reduced.

In order to obtain practical display characteristics in the FED having the above-described structure, it is necessary to use a phosphor surface in which phosphors similar to those of ordinary cathode-ray tubes are used and an aluminum thin film, which is called "metal back", is formed on the phosphors. In this case, the anode voltage, which is to be applied to the phosphor surface, should be set preferably at several kV, and more preferably at 10 kV or more.

However, the gap between the front substrate and back substrate cannot excessively be increased, from the standpoint of characteristics of resolution and spacers. The gap needs to be set at about 1 to 2 mm. Thus, in the FED, it is inevitable that an intense electric field is produced in a small gap between the front substrate and back substrate, and discharge between both substrates becomes a problem.

If discharge occurs, damage or performance degradation is caused on the phosphor surface or driving circuits. Such damage or performance degradation is generally referred to as discharge damage. In order to put the FED to practical use, it is necessary to prevent discharge damage from occurring over a long period. It is very difficult, however, to realize this.

It is thus important to take a measure to suppress discharge current so that the effect of discharge on the electron emitter elements, phosphor surface and driving circuits may be ignored. A technique for this is disclosed, wherein notches are formed in a metal back that is provided on a phosphor surface and, for example, a zigzag pattern is formed, thereby to increase an effective impedance of the phosphor surface (see, e.g. Jpn. Pat. Appln. KOKAI Publication No. 2000-311642). In addition, a technique is disclosed, wherein a metal back is divided, and the divided parts of the metal back are connected to a common electrode via a resistor member, thereby applying a high voltage (see, e.g. Jpn. Pat. Appln. KOKAI Publication No. 10-326583). Furthermore, a technique has been disclosed, wherein a coating of an electrically conductive material is provided on divided parts of a metal back, thereby to suppress a surface creeping discharge at the divided parts (see, e.g. Jpn. Pat. Appln. KOKAI Publication No. 2000-251797).

By these prior-art techniques, the discharge current can greatly be reduced, but the discharge current, in some cases, cannot exactly be reduced to a target value or less. A tolerable current for driver ICs, which drive electron emitter elements and the FED, should preferably be set at several amperes or less as practical values. In order to exactly suppress the discharge current to this tolerable current value or less, it is necessary to increase the withstand voltage of the divided parts and to set the resistance of divided parts and the resistance of the connection resistor at desired values.

However, resistor materials, which are convenient in order to satisfy the above requirements, have not been discovered. Even if such materials are discovered in the future, it is desirable to reduce as much as possible the amount of the resistor material to be used and the number of formation processes such as printing, from the standpoint of cost and yield. In the prior-art structures, however, the resistance adjustment for the divided parts and the connection resistor has to be performed with use of different members, and the above requirements cannot be satisfied.

Disclosure of Invention

The present invention has been made in consideration of the above-described problems, and the object of the invention is to provide an image display device which can exactly control discharge current of discharge occurring between a front substrate and a back substrate, and, if discharge occurs, can prevent damage and performance degradation of electron emitter elements, the phosphor surface and driving circuits.

According to an aspect of the invention, there is provided an image display device comprising:

a front substrate having a phosphor screen which includes a phosphor layer and a light-blocking layer, a metal back layer which is laid over the phosphor screen and is composed of a plurality of divisional electrodes, a common electrode for applying a voltage to the metal back layer, and a connection resistor which connects the metal back layer and the common electrode; and

a back substrate which is disposed to be opposed to the front substrate and is provided with electron emitter elements which emit electrons toward the phosphor screen,

wherein a first gap gs is provided between neighboring the divisional electrodes in a first region As on the front substrate,

a second gap ge, which is greater than the first gap gs, is provided between neighboring the divisional electrodes in a second region Ae which is located at a periphery of the first region As, and

the second region Ae includes, at least at a part thereof, a region Aer having a lower resistance than the first region As.

Brief Description of Drawings

FIG. 1 is a perspective view that schematically shows an example of an image display device according to an embodiment of the present invention;

FIG. 2 is a cross-sectional view taken along line A-A in FIG. 1, and schematically shows a cross-sectional structure of the image display device;

FIG. 3 is a plan view that schematically shows the structure of a front substrate of the image display device according to the embodiment of the invention;

FIG. 4 is a cross-sectional view that schematically shows the structure of the front substrate shown in FIG. 3;

FIG. 5 is a view for explaining the connectional relationship between divisional electrodes and a common electrode on the front substrate shown in FIG. 3;

FIG. 6 is a view for explaining the connectional relationship between divisional electrodes and a connection resistor on the front substrate shown in FIG. 3; and

FIG. 7 is a view for describing the relationship between a division pitch of divisional electrodes and a pixel pitch.

Best Mode for Carrying Out the Invention

An image display device according to an embodiment of the present invention will now be described with reference to the accompanying drawings. An FED having surface-conduction electron emitter elements is described as an example of the image display device.

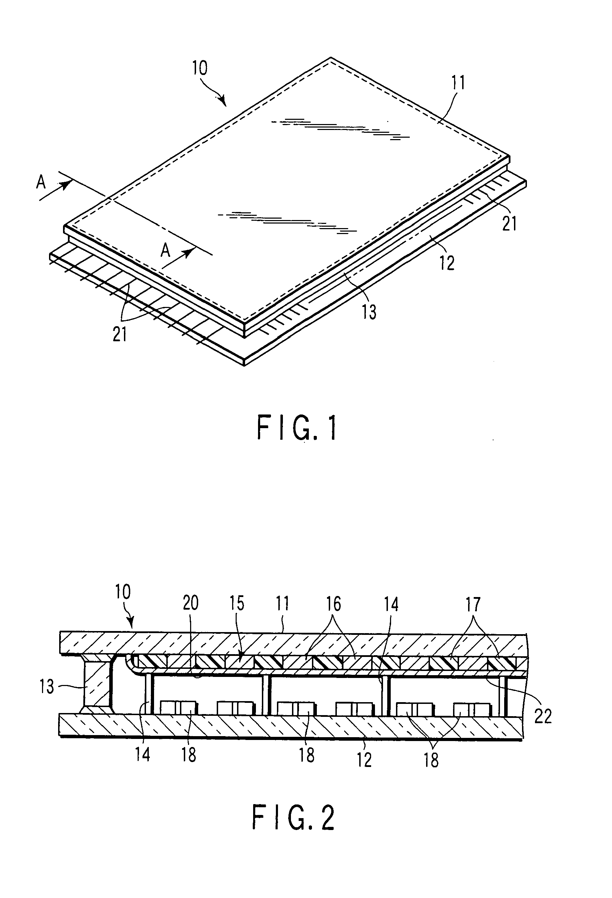

As is shown in FIG. 1 and FIG. 2, the FED includes a front substrate 11 and a back substrate 12, which are disposed to be opposed to each other with a gap of 1 to 2 mm. Each of the front substrate 11 and back substrate 12 is formed of a rectangular glass plate. Peripheral edge parts of the front substrate 11 and back substrate 12 are attached via a rectangular-frame-shaped side wall 13, thereby forming a flat, rectangular vacuum envelope 10 in which a high degree of vacuum of $10^{-4}$ Pa or less is maintained.

A plurality of spacers 14, which support an atmospheric pressure load acting on the front substrate 11 and back substrate 12, are provided between the front substrate 11 and back substrate 12 within the vacuum envelope 10. The spacers 14 may be plate-like ones or columnar ones.

The front substrate 11 has an image display surface on its inside. Specifically, the image display surface is composed of a phosphor screen 15 and a metal back layer 20 that is disposed on the phosphor screen 15. The image display surface may include, where necessary, a getter film 22 which is disposed on the metal back layer 20.

The phosphor screen 15 is composed of phosphor layers 16, which emit red, green and blue light, and a light blocking layer 17 which is disposed in a matrix shape. The metal back layer 20 is formed of an electrically conductive material such as aluminum, and functions as an anode. At a time of operation for displaying an image, a predetermined anode voltage is applied to the metal back layer 20. The getter film 22 is formed of a metal film with gas adsorption properties, and the getter film 22 adsorbs a gas remaining within the vacuum envelope 10 and an emission gas from the substrates.

The back substrate 12 has surface-conduction electron emitter elements 18 on its inner surface. The electron emitter elements 18 function as electron emitter sources which emit electron beams for exciting the phosphor layers 16 of the phosphor screen 15. Specifically, these electron emitter elements 18 are arranged on the back substrate 12 in columns and rows in association with pixels, and emit electron beams toward the phosphor layers 16. Each of the electron emitter elements 18 comprises an electron emission part and a pair of element electrodes for applying a voltage to the electron emission part, which are not shown. A great number of wiring lines 21 for driving the electron emitter elements 18 are provided in a matrix on the inner surface of the back substrate 12, and end portions of the wiring lines 21 are led out of the vacuum envelope 10.

In the FED, at the time of operation for displaying an image, an anode voltage is applied to the image display surface via the metal back layer 20. The electron beams, which are emitted from the electron emitter elements 18, are accelerated by the anode voltage and caused to strike the phosphor screen 15. Thereby, the phosphor layers 16 of the phosphor screen 15 are excited and caused to emit light of associated colors. Thus, a color image is displayed on the image display surface.

Next, a detailed structure of the metal back layer 20 in the FED having the above-described structure is described. The term "metal back layer", in this context, refers to not only a layer of a metal, but also layers of various materials. For convenience, the term "metal back layer" is used.

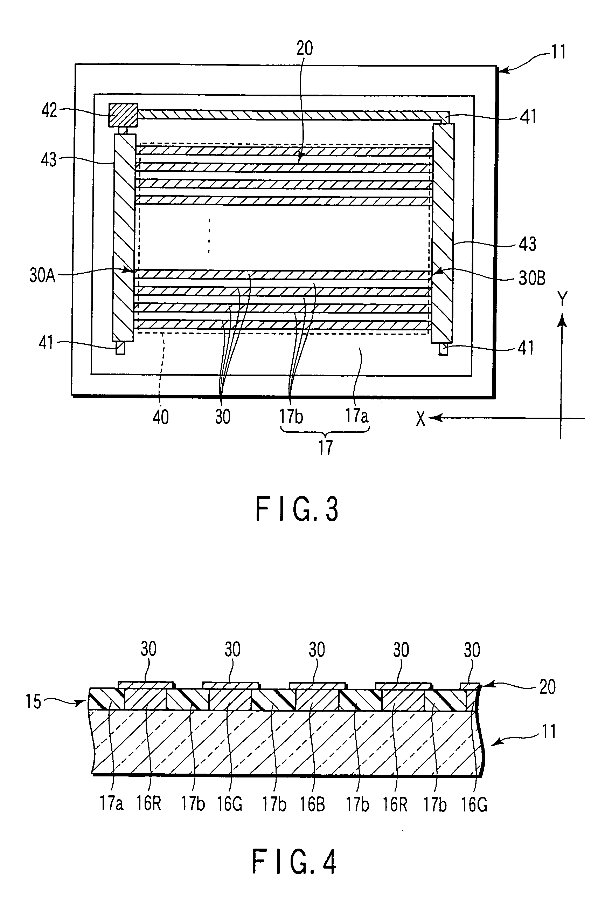

As is shown in FIG. 3 and FIG. 4, the phosphor screen 15 includes a great number of rectangular phosphor layers 16 (R, G, B) which emit red, blue and green light. These phosphor layers 16 (R, G, B) are mainly arranged in an effective section 40 which substantially displays an image. In the case where the longitudinal direction of the front substrate 11 is set to be a first direction X and the width direction that is perpendicular to the first direction X is set to be a second direction Y, the red phosphor layers 16R, green phosphor layers 16G and blue phosphor layers 16B are alternately arranged with predetermined gaps in the first direction X. In addition, the same-color phosphor layers 16 (R, G, B) are arranged with predetermined gaps in the second direction. The phosphor screen 15 includes a light-blocking layer 17. The light-blocking layer 17 includes a rectangular frame part 17a which is disposed on a peripheral edge part of the front substrate 11, and matrix parts 17b which are disposed between the phosphor layers (R, G, B) within the rectangular frame part 17a.

The metal back layer 20 is composed of a plurality of insular divisional electrodes 30. The divisional electrodes 30 are mainly disposed on the phosphor layer 16 and are formed as stripes extending in the first direction X.

A common electrode 41 is formed on an outside of the effective section 40. The common electrode 41 is connected to a high voltage supply section 42. The common electrode 41 is configured such that a high voltage can be applied to the common electrode 41 via the high voltage supply section 42 by a proper means. The high voltage supply section 42 may not be provided separately, and a part of the common electrode 41 may be formed as a high voltage supply section (i.e., the common electrode 41 and high voltage supply section 42 may be integrally formed).

The common electrode 41 extends in a direction (i.e., second direction Y) which is perpendicular to the direction of extension (i.e., first direction X) of the divisional electrodes 30. Specifically, the common electrode 41 is formed as a stripe on one end portion 30A side and the other end portion 30B side of the stripe-shaped divisional electrodes 30, with a predetermined gap from each divisional electrode 30.

The common electrode 41 and divisional electrodes 30 are electrically connected via a connection resistor 43. Specifically, one end portion 30A of each divisional electrode 30 is electrically connected to the common electrode 41 via the connection resistor 43, and the other end portion 30B of each divisional electrode 30 is similarly electrically connected to the common electrode 41 via the connection resistor 43.

Assume now that a voltage occurring at each divisional electrode 30 is Vga, and a resistance of the resistor, which is connected to each divisional electrode 30, is Rg. Also assume that a withstand voltage between neighboring divisional electrodes 30 is Vgb. In this case, in order to suppress discharge between the divisional electrodes 30, the relationship, Vga < Vgb, has to be established. If this relationship is not established, discharge will occur between the neighboring divisional electrodes 30, and discharge current will not be controlled and will increase.

The voltage Vga becomes smaller as the resistance Rg is decreased. However, if the resistance Rg is excessively decreased, discharge current Ibd, which flows at the time of occurrence of discharge, becomes too large. According to a result of studies, it is not ensured to set the withstand voltage Vgb at 1.5 kV or more. On the other hand, a target value (tolerance value) of the discharge current Ibd is set at 5 A or less, e.g., at 3 A. It is difficult to set a higher discharge current than this to be a tolerable current, because the cost of driver ICs would excessively increase.

According to a result of studies using an electric circuit simulator, the relationship, Rg < 10 kΩ, needs to be established in order to set the voltage Vga between the divisional electrodes at 1.5 kV or less. In addition, the relationship, Rg > 0.1 kΩ, needs to be established in order to set the discharge current Ibd at 5 A or less. In short, the resistance Rg of the resistor material is selectable in a range between 0.1 kΩ and 10 kΩ. The optimal range of the resistance varies depending on the pixel size or the number of pixels, but the degree of dependency is small. Therefore, this result can be generalized.

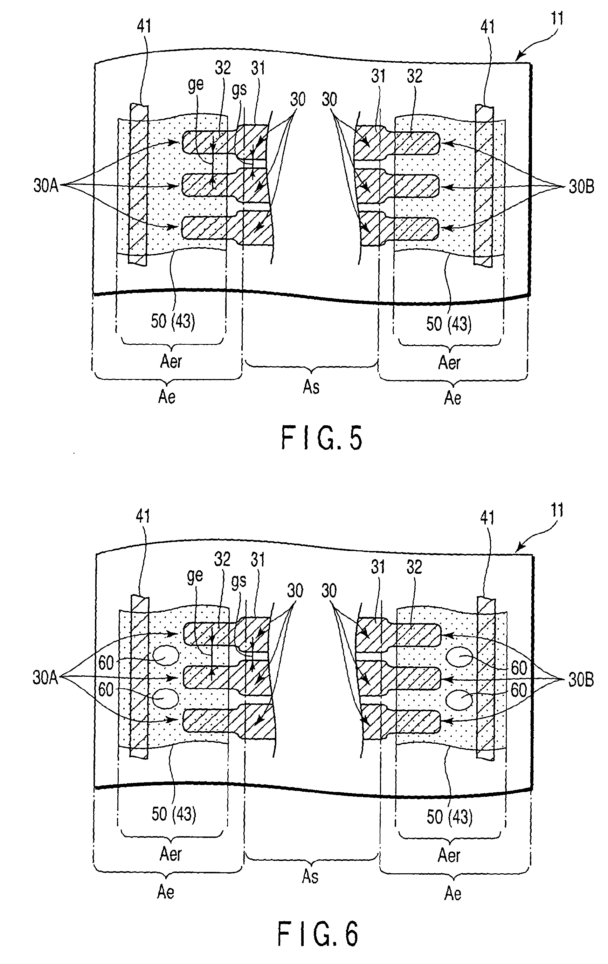

Consideration will now be given to a structure which can satisfy both the optimization of the resistance value Rg and the withstand voltage Vgb. In the present embodiment, as shown in FIG. 5, a resistance material 50 is disposed at least at one end portion of each divisional electrode 30, and the resistance value Rg that is to be optimized is mainly formed at the end portion of each divisional electrode 30. FIG. 5 shows an example in which resistor materials 50 are disposed at both end portions of the divisional electrodes 30. It is possible, however, to dispose the resistor material 50 at one end portion alone. The resistor material 50 may be the same as the connection resistor 43, or may be different. It is also possible that the divisional electrodes 30 may be connected only at one end to the common electrode 41 via the connection resistor 43, and the divisional electrodes 30 may be connected at the other end via the resistor material 50.

It is not necessary to form the connection resistor 43 and resistor material 50 at the same time. However, by forming the connection resistor 43 and resistor material 50 of the same material at the same time (or by integrally forming the connection resistor 43 and resistor material 50), the number of fabrication steps can be reduced and the manufacturing cost can be reduced.

As shown in FIG. 5, a first region As and second regions Ae are defined in the front substrate 11. The first region As may correspond to the above-described effective section 40, or may correspond to a region smaller or larger than the effective section 40. The second regions Ae correspond to peripheral parts of the first region As.

In the first region As, a first gap gs is provided between neighboring divisional electrodes 30. In the second region Ae, a second gap ge, which is greater than the first gap gs, is provided between neighboring divisional electrodes 30. Specifically, the divisional electrodes 30 extend not only in the first region As but also in the second region Ae. In this case, the common electrode 41 is disposed in the second region Ae. The divisional electrode 30 includes a first electrode portion 31 with a relatively large line width at a central part thereof, and second electrode portions 32 with a less line width than the first electrode portion 31 at both end portions thereof (i.e., at one end portion 30A and the other end portion 30B). In short, one end portion 30A and the other end portion 30B of the divisional electrode 30 are disposed in the second regions Ae and constitute the second electrode portions 32. The first electrode portion 31 of the divisional electrode 30 is disposed in the first region As. In other words, the first region As corresponds to a region where the first electrode portion 31 of the divisional electrode 30 is mainly disposed, and the second region Ae corresponds to a region where the second electrode portion 32 of the divisional electrode 30 is mainly disposed.

In this case, a first gap gs is provided between the first electrode portions 31 of neighboring divisional electrodes 30. A second gap ge is provided between the second electrode portions 32 of neighboring divisional electrodes 30. The second gap ge is provided between the second electrode portions 32 each having a less line width than the first electrode portion 31. Thus, the second gap ge is greater than the first gap gs that is provided between the first electrode portions 31. With this structure, gaps between the neighboring divisional electrodes can be increased at both end portions of the divisional electrodes, and discharge can be prevented from occurring therebetween.

On the other hand, the second region Ae includes, at least at a part thereof, a region Aer having a lower resistance than the first region As. The region Aer is formed of the resistor material 50. For example, the resistor material 50 is formed by printing and baking a paste in which a high-resistance metal oxide is dispersed in low-melting-point glass.

To be more specific, since the neighboring divisional electrodes are electrically connected by disposing the resistor material 50 in the second region Ae, the resistance Rg is obtained mainly by the second region Ae. Thus, in the first region As, consideration may given only to the withstand voltage between the divisional electrodes 30 (i.e., between the first electrode portions 31). In addition, in the second region Ae, the resistor material 50 is usable for adjustment of the resistance Rg. In the case where the resistor materials 50 are disposed at both end portions of the divisional electrodes 30, the resistance Re at the second region Ae is expressed by

$$Re = (\rho s \cdot W/L)/2.$$

In the state in which the resistance Rs on the first region As side is set to be sufficiently higher than the resistance Re at the second region Ae (Re < Rs), approximation of Rg ≅ Re is possible. In the equation, ps represents a sheet resistance of the resistor material 50. The resistor material 50 used here should preferably be formed of a material having a sheet resistance of about 1E3 to 1E5 $\Omega/\square$. Symbol W represents the gap between neighboring electrodes 30 in the second region Ae (i.e., between second electrode portions 32). The gap W is determined on the basis of the withstand voltage Vgb between the divisional electrodes 30. Symbol L represents the length of the divisional electrode 30 extending from the first region As to the second region Ae. The resistance Re can be adjusted by adjusting L.

As described above, in the second region Ae, the resistance Re (≅ Rg) can be set in the optimal range by adjusting the length L of the second electrode portion 32 of the divisional electrode 30. In addition, the withstand voltage Vgb can be secured by adjusting the gap W between the second electrode portions 32.

Next, a modification of the embodiment is described.

In order to prevent an excessive increase in discharge current when discharge occurs, it is necessary that the resistance of the resistor material 50 disposed at end portions of the divisional electrodes 30 be 0.5 MΩ or more. However, if reduction in resistance Rg is required when optimization of the resistance Rg in a predetermined range is required, it is very difficult to satisfy both the requirements with the use of the solid film as shown in FIG. 5. Thus, the resistor material 50 is formed to have a predetermined pattern for controlling the resistance thereof.

Specifically, as shown in FIG. 6, the resistor material 50 has a pattern with openings 60 in parts thereof. The openings 60 are formed between the second electrode portions 32 and the common electrode 41 in the second region Ae. The openings 60 substantially restrict the width of the resistor material 50 which connect the second electrode portions 32 and the common electrode 41. By adjusting the size and shape of each opening 60, the resistance of the resistor material 50 can easily be adjusted. When the resistor material 50 is formed by screen printing, these openings 60 can be formed by a shield pattern on the screen.

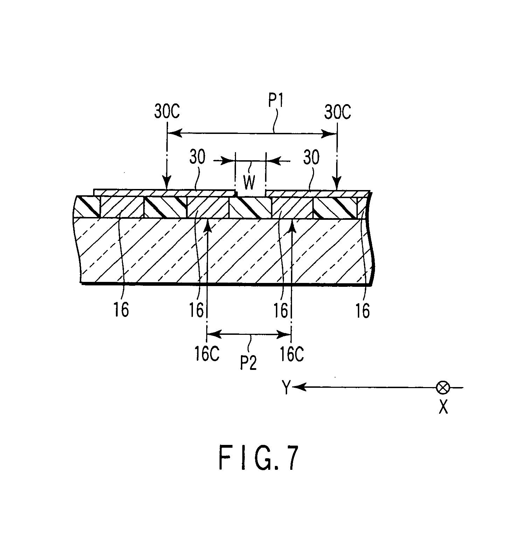

In the above-described embodiment, the division pitch of the divisional electrodes 30 should preferably be greater than the pitch of pixels. Specifically, as shown in FIG. 7, the division pitch P1 corresponds to a distance in the second direction Y between centers 30C of the neighboring divisional electrodes 30. The pixel pitch P2 corresponds to a distance in the second direction Y between centers 16C of the neighboring phosphor layers 16. If the division pitch P1 is equal to the pixel pitch P2 (i.e., multiplication factor of 1), there is a concern that the gap W between the neighboring divisional electrodes 30 cannot sufficiently be increased (i.e., sufficient withstand voltage cannot be secured). On the other hand, as the division pitch P1 is greater than the pixel pitch P2, a higher discharge current tends to flow when discharge occurs. It is thus desirable to set the division pitch P1 to be at least about double the pixel pitch P2, and to be at most about three or four times the pixel pitch P2 (in FIG. 7 the division pitch P1 is double the pixel pitch P2).

As has been described above, the present embodiment can provide an image display device wherein even if discharge occurs between the front substrate and the back substrate, the discharge current at this time can be sufficiently reduced and damage due to discharge can be suppressed. Thereby, the anode voltage can be increased or the gap between the front substrate and back substrate can be decreased, and thus the embodiment can provide an image display device having enhanced display characteristics of, e.g., luminance and resolution.

The present invention is not limited to the above-described embodiment. At the stage of practicing the invention, various embodiments may be made by modifying the structural elements without departing from the spirit of the invention. Structural elements disclosed in the embodiment may properly be combined, and various inventions may be made. For example, some structural elements may be omitted from the embodiment. Moreover, structural elements in different embodiments may properly be combined.

Industrial Applicability

The present invention can provide an image display device which can exactly control discharge current of discharge occurring between a front substrate and a back substrate, and, if discharge occurs, can prevent damage and performance degradation of electron emitter elements, the phosphor surface and driving circuits.

**Claims**

1. An image display device **characterized by** comprising:

   a front substrate having a phosphor screen which includes a phosphor layer and a light-blocking layer, a metal back layer which is laid over the phosphor screen and is composed of a plurality of divisional electrodes, a common electrode for applying a voltage to the metal back layer, and a connection resistor which connects the metal back layer and the common electrode; and
   a back substrate which is disposed to be opposed to the front substrate and is provided with electron emitter elements which emit electrons toward the phosphor screen,
   wherein a first gap gs is provided between neighboring said divisional electrodes in a first region As on the front substrate,
   a second gap ge, which is greater than the first gap gs, is provided between neighboring said divisional electrodes in a second region Ae which is located at a periphery of the first region As, and
   the second region Ae includes, at least at a part thereof, a region Aer having a lower resistance than the first region As.

2. The image display device according to claim 1, **characterized in that** Re < Rs, when a resistance formed in the first region As is Rs, and a resistance formed in the second region Ae is Re.

3. The image display device according to claim 1, **characterized in that** the region Aer includes a resistor material which is formed of the same material as the connection resistor.

4. The image display device according to claim 1, **characterized in that** the region Aer includes a resistor material which is formed integral with the connection resistor.

5. The image display device according to claim 4, **characterized in that** the resistor material is formed to have a predetermined pattern which controls a resistance value of the resistor material.

6. The image display device according to claim 5, **characterized in that** the resistor material is formed to have a predetermined pattern, in a part of which an opening is formed.

7. The image display device according to claim 1, **characterized in that** a pitch of the divisional electrodes is two times, three times or four times greater than a pixel pitch.

FIG. 1

FIG. 2

FIG.3

FIG.4

FIG.5

FIG.6

FIG. 7

## INTERNATIONAL SEARCH REPORT

| | International application No. |
|---|---|
| | PCT/JP2005/005931 |

A. CLASSIFICATION OF SUBJECT MATTER
   Int.Cl⁷ H01J31/12, 29/28

According to International Patent Classification (IPC) or to both national classification and IPC

B. FIELDS SEARCHED

Minimum documentation searched (classification system followed by classification symbols)
   Int.Cl⁷ H01J31/12, H01J29/28, H01J29/92

Documentation searched other than minimum documentation to the extent that such documents are included in the fields searched
   Jitsuyo Shinan Koho        1922-1996   Jitsuyo Shinan Toroku Koho   1996-2005
   Kokai Jitsuyo Shinan Koho  1971-2005   Toroku Jitsuyo Shinan Koho   1994-2005

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2002-100313 A (Canon Inc.),<br>05 April, 2002 (05.04.02),<br>Full text; all drawings<br>& US 2002/47661 A1        & US 2003/67275 A1 | 1-7 |
| A | JP 2001-243893 A (Sony Corp.),<br>07 September, 2001 (07.09.01),<br>Full text; all drawings<br>& US 6771236 B1 | 1-7 |
| A | JP 10-326583 A (Canon Inc.),<br>08 December, 1998 (08.12.98),<br>Full text; all drawings<br>& EP 0866491 A2        & US 6677706 B1<br>& CN 1208944 A | 1-7 |

| ☒ | Further documents are listed in the continuation of Box C. | ☐ | See patent family annex. |
|---|---|---|---|

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 27 June, 2005 (27.06.05) | 12 July, 2005 (12.07.05) |

| Name and mailing address of the ISA/ | Authorized officer |
|---|---|
| Japanese Patent Office | |
| Facsimile No. | Telephone No. |

Form PCT/ISA/210 (second sheet) (January 2004)

**INTERNATIONAL SEARCH REPORT**

| International application No. |
|---|
| PCT/JP2005/005931 |

C (Continuation).    DOCUMENTS CONSIDERED TO BE RELEVANT

| Category* | Citation of document, with indication, where appropriate, of the relevant passages | Relevant to claim No. |
|---|---|---|
| A | JP 10-134740 A  (Futaba Corp.),<br>22 May, 1998 (22.05.98),<br>Full text; all drawings<br>(Family: none) | 1-7 |
| A | US 5628662 A  (Kenneth G. Vickers),<br>13 May, 1997 (13.05.97),<br>Full text; all drawings<br>(Family: none) | 1-7 |
| P,A | JP 2005-11700 A  (Toshiba Corp.),<br>13 January, 2005 (13.01.05),<br>Full text; all drawings<br>& WO 2004/114351 A1 | 1-7 |

Form PCT/ISA/210 (continuation of second sheet) (January 2004)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000311642 A
- JP 10326583 A
- JP 2000251797 A